# EUROPEAN PATENT APPLICATION

(11) **EP 0 810 477 A2**
(43) Date of publication of application: **03.12.1997**
(21) Application number: 97303497.8
(22) Date of filing: 22.05.1997
(51) Int. Cl.: G03F 7/095, G03F 7/20

(54) **Photoactive systems for high resolution photolithography**

(30) Priority: 24.05.1996 US 18328
(71) Applicant: TEXAS INSTRUMENTS INCORPORATED, Dallas Texas 75265 (US)
(72) Inventor: Palmer, Shane R., Dallas, Texas 75243 (US)
(74) Representative: Darby, David Thomas

(57) **Abstract**

One embodiment of the instant invention is a photoresist system for high resolution lithography for fabrication of semiconductor devices, the photoresist system comprising: a first photoactive compound which is activated at a first value of a characteristic to create a first reaction; a second photoactive compound which is activated at a second value of the characteristic which is different than the first value of the characteristic; and wherein the activation of the second photoactive compound annuls the first reaction. In another embodiment of the instant invention, the characteristic is an energy level. The first value of the characteristic may be less than the second value of the characteristic, or the first value of the characteristic is greater than the second value of the characteristic. In one variation of this embodiment, regions of the photoresist system that are exposed to energy at least as great as the first value but not as great as the second value becomes more soluble in a subsequent rinse step and regions of the photoresist system that are exposed to energy greater than the second value become less soluble in the subsequent rinse step. In another variation of this embodiment, regions of the photoresist system that are exposed to energy at least as great as the first value but not as great as the second value becomes less soluble in a subsequent rinse step and regions of the photoresist system that are exposed to energy greater than the second value become less soluble in the subsequent rinse step. In another embodiment of the instant invention, the characteristic is frequency or it involve the chemical makeup.

## Description

### FIELD OF THE INVENTION

The instant invention pertains to semiconductor device fabrication and processing and more specifically to high resolution lithography.

### BACKGROUND OF THE INVENTION

Photoresists utilized in the semiconductor industry are designed to operate with either positive or negative functionality. The positive (or negative) class of resists are materials which become more (or less) soluble in a developer after exposure to radiation. There are several mechanisms which have been used to create these functionalities. One widely used mechanism for changing the solubility of a resist is to include a radiation sensitive material, referred to as a photoactive component (PAC) or a photoactive group (PAG), which is built onto an alkali matrix resin, i.e. a phenolic (novalac™) polymer backbone such as naphthoquinonediazide (DNQ) resins. The addition of dissolution inhibitor PACs from the amine group, for example, changes the solubility of the DNQ resist in an aqueous base solution such as tetramethylammonium hydroxide (TMAH). Upon irradiation the dissolution inhibitor PAC becomes acidic resulting in a change in the dissolution behavior for the exposed regions which can then be removed by the TMAH development. This is just one example of how to create a positive resist system.

The negative functionality for a resist can be achieved by including a PAC which instead of initially inhibiting the dissolution creates a crosslinking reaction of the polymer after radiation exposure. Commonly used PACs include compounds from the azide group which are attached to the polymer chain. The crosslinking of the polymer matrix by the PAC after exposure by radiation (light, electrons, ions, etc.) causes the normally soluble material to then become insoluble under TMAH development.

Depending on the type of PAC that is utilized, photoresists can be either positive or negative. If the photoresist system is positive then the photoresist will remain intact except for the portion of the photoresist that is exposed to the energy source. In a negative photoresist system the opposite occurs. More specifically, only the portions of the photoresist that are exposed to the energy source will remain intact.

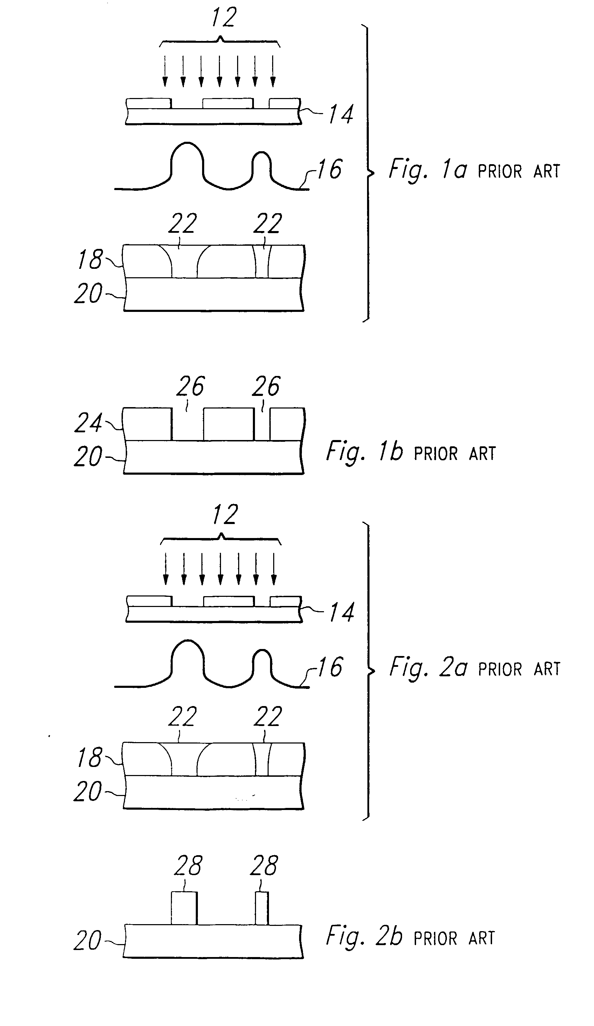

An example of a positive photoresist system is depicted in FIGUREs 1a and 1b, and an example of a negative photoresist system is depicted in FIGUREs 2a and 2b. In both of these systems, incident energy 12 is passed through or blocked by mask 14. The distribution of incident energy upon photoresist 18, which is formed on wafer 20, is depicted by graph 16. Regions 22 illustrate the portions of photoresist that are affected by the impinging incident energy. As is illustrated by FIGURE 1b, the regions of photoresist that are exposed to the impinging energy (regions 22) become devoid of photoresist (regions 26). However, as is illustrated in FIGURE 2b, in a negative photoresist system the regions of photoresist 18 that are exposed to the impinging energy (regions 22) are all that remain (regions 28).

In order to achieve better resolution for smaller features and for non-planar features, image reversal can be utilized. Typically, image reversal is accomplished by exposing portions of a positive photoresist to an energy source (e.g. a light source), baking the exposed photoresist so as to change the photoresist from a positive resist to a negative resist, and then performing a flood exposure. Note, the image reversal technique described here operates on the entire volume of the photoresist, that is, all of the previously soluble regions (which were exposed to radiation) become insoluble and all of the unexposed regions become soluble. The original photoresist material had only one functionality, positive, and after the image reversal, the entire photoresist has only one functionality, negative. One cannot selectively choose an isolated region of the exposed pattern and have it change functionality. Regardless, this type of image reversal is beneficial because it provides some control over the sidewalls of the photoresist. More specifically, structure widths as defined by positive photoresist are determined by the foot of the photoresist. Whereas, structure widths, as defined by negative photoresist, are determined by top of the photoresist.
Therefore, using this type of image reversal, the planarity of the underlying layer is not critical because the features are defined by the top of the photoresist and not the bottom. While this type of image reversal may provide better resolution, it may not be practical for most semiconductor device process flows, because it is typically not practical to bake the semiconductor wafer after the first exposure.

Another method of creating an image reversal utilizes a high energy source, such as an electron or ion beam, instead of a heat source. While this method does not have the problems that the baking method has and it can locally define regions of reversal, it, too, is not very practical because it involves equipment that is not implemented on standard processing equipment. Another problem with this method involves subjecting the existing semiconductor structures to high energy.

In summary, either positive or negative photoresist can be used as a mask to define semiconductor structure. However, image reversal methods may be preferable to obtain better resolution. Image reversal is accomplished by exposing a portion of positive photoresist, then physically altering the photoresist from positive to negative by subjecting the positive photoresist to either high energy or baking, and then subjecting the altered photoresist to a flood exposure.

It is, therefore, an object of the instant invention to provide a method of altering a photoresist from positive or negative to the opposite polarity. It is also an object of the instant invention to provide a photoresist system which provides improvement to the depth to focus and resolution.

### SUMMARY OF THE INVENTION

One embodiment of the instant invention involves using the same resist polymer which can be energetically selected to be positive or negative. Two possible combinations for such a resist system involve a low-energy activated negative component with a high-energy activated positive component or a low-energy activated positive component with a high-energy activated negative component. In other words, a resist system which is basically positive (or negative), under standard radiation levels, that has within its backbone the ability to undo the first reaction by the inclusion of a second material which is activated by an even higher radiation level (or frequency).

One embodiment of the instant invention is a photoresist system for high resolution lithography for fabrication of semiconductor devices, the photoresist system comprising: a first photoactive compound which is activated at a first value of a characteristic to create a first reaction; a second photoactive compound which is activated at a second value of the characteristic which is different than the first value of the characteristic; and wherein the activation of the second photoactive compound annuls the first reaction. In another embodiment of the instant invention, the characteristic is an energy level. The first value of the characteristic may be less than the second value of the characteristic, or the first value of the characteristic is greater than the second value of the characteristic. In one variation of this embodiment, regions of the photoresist system that are exposed to energy at least as great as the first value but not as great as the second value becomes more soluble in a subsequent rinse step and regions of the photoresist system that are exposed to energy greater than the second value become less soluble in the subsequent rinse step. In another variation of this embodiment, regions of the photoresist system that are exposed to energy at least as great as the first value but not as great as the second value becomes less soluble in a subsequent rinse step and regions of the photoresist system that are exposed to energy greater than the second value become less soluble in the subsequent rinse step. In another embodiment of the instant invention, the characteristic is frequency or it involves the chemical makeup.

Another embodiment of the instant invention is a method of fabricating semiconductor devices using high resolution lithography, the method comprising the steps of: providing a semiconductor wafer; forming layers of material on the semiconductor wafer; patterning the layers by forming a photoresist layer on the layers, the photoresist layer comprised of a first photoactive compound which is activated at a first energy level so as to create a first reaction and a second photoactive compound which is activated at a second energy level which is greater than the first energy level; and wherein the activation of the second photoactive compound annuls the first reaction so as to provide the higher resolution lithography. In one variation of this embodiment, regions of the photoresist layer that are exposed to energy at least as great as the first energy level but not as great as the second energy level becomes more soluble in a subsequent rinse step and regions of the photoresist layer that are exposed to energy greater than the second energy level become less soluble in the subsequent rinse step. In another variation of this embodiment, regions of the photoresist layer that are exposed to energy at least as great as the first energy level but not as great as the second energy level become less soluble in a subsequent rinse step and regions of the photoresist layer that are exposed to energy greater than the second energy level become less soluble in the subsequent rinse step.

Another embodiment of the instant invention is a method of patterning a resist layer comprising the steps of: forming a resist layer on a substrate material; directing radiation with a first energy level toward a first portion of the resist layer, the radiation interacting with the resist so as to make the resist layer more soluble; and directing radiation with a second energy level toward a second portion of the resist layer, the radiation interacting with the second portion of the resist layer so as to make the second portion of the resist layer less soluble. The first energy level may either be greater than the second energy level, or less than the second energy level.

### BRIEF DESCRIPTION OF THE DRAWINGS

The present invention will now be further described, by way of example, with reference to the accompanying drawings in which:
FIGUREs 1a and 1b are cross-sectional views of a known positive photoresist system in which FIGURE 1b illustrates a positive photoresist layer after it has been selectively exposed;
FIGUREs 2a and 2b are cross-sectional views of a known negative photoresist system in which FIGURE 2b illustrates a negative photoresist layer after it has been selectively exposed;
FIGUREs 3a and 3b are cross-sectional views of a photoresist system of one embodiment of the instant invention;
FIGURE 3b illustrates the photoresist layer of the embodiment of Figure 3a after it has been selectively exposed;
FIGUREs 4a and 4b are cross-sectional views of a photoresist system of another embodiment of the instant invention; and
FIGURE 4b illustrates the photoresist layer of this embodiment of the instant invention after it has been selectively exposed.

### DETAILED DESCRIPTION OF THE DRAWINGS

While the following discussion of the embodiments of the instant invention involve a photoresist material that is comprised of two different PACs, PAGs, or acid generators which are activated at different energy levels, the instant invention can also be implemented wherein several different PACs are included in one photoresist material. In addition, the PACs may be activated at different energy levels, or they may be activated by different frequencies, different temperatures, or using different chemical solvents. Therefore, while the following discussion involves two PACs and energy levels, it should be read to encompass multiple PACs and varying energy levels, temperature levels, frequencies, or chemical solvents.

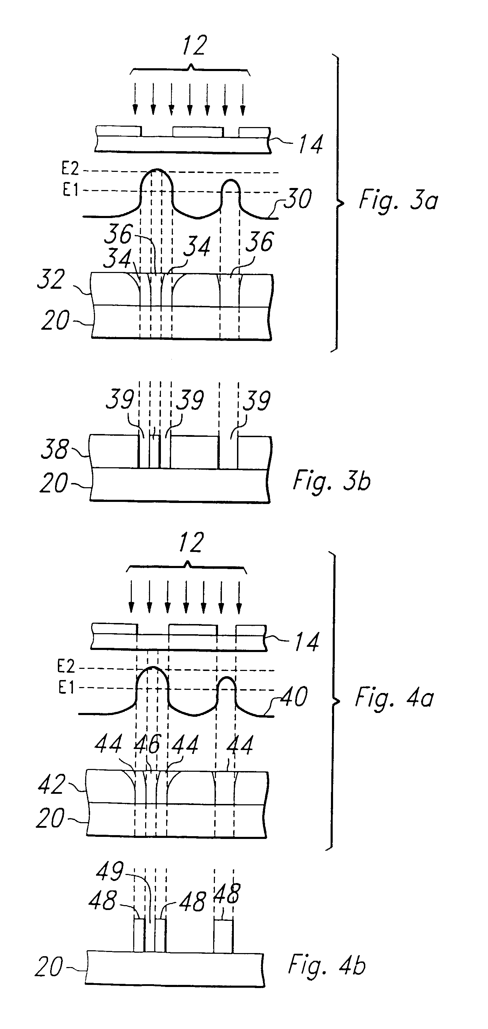

FIGURE 3a illustrates one embodiment of the instant invention. In the photoresist system of FIGURE 3a, negative PACs, included in photoresist layer 32, are activated by exposure energies of greater than energy level E2. In addition, positive PACs, included in photoresist layer 32 are activated at energy levels greater than El but less than E2. Hence, due to diffraction, the resultant energy (see graph 30) of incident energy passing through mask 14 yields a photoresist layer that has regions which become positive (regions 34 and 36) and others that become negative (36). Therefore, with one exposure of energy and one mask, patterned photoresist layer 38 (FIGURE 3b) is formed with very small features (such as the features situated between voids 39, which were formed due to the exposure of the positive PACs in the photoresist layer).

This type of positive to negative photoresist system is preferably a polymer chain which includes two photolabile groups which have different activation energy/frequency/temperature levels. In the case of energy activation, the photoresist would include PACs which would correspond to the main chain scission reaction (bond breaking) when exposed to the lower energy level, and that would therefore be in a higher soluble state than the unexposed region. In addition, the polymer would include PACs that preferably include a photo-active ingredient (carried within the backbone of the scissioned chain) that would repolymerize the chain upon the introduction of the higher exposure energy so as to be insoluble in a subsequent rinse.

FIGURE 4a illustrates another embodiment of the instant invention. This type of photoresist system is a negative to positive system. In other words, regions of photoresist layers that are exposed to energies of greater than E2 become activated such that they exhibit positive photoresist qualities. Hence, regions that are exposed to energies of greater than E2 become soluble (or more soluble) in a subsequent rinse step (see regions 46 and 49). Regions of photoresist that are exposed to energies of between E1 and E2, exhibit negative photoresist qualities because only the negative PACs become activated. Therefore, regions of photoresist that are exposed to energies between E1 and E2 become less soluble (or insoluble) in a subsequent rinse step (see regions 44 and 48). Regions of photoresist 42 that are not exposed to energies with an energy level of at least E1 are not activated. In other words, neither the positive nor the negative PACs in these regions are activated. Hence, these regions are more soluble in a subsequent rinse step.

This type of negative to positive photoresist system is preferably a polymer which is cross linked at a low energy so as to make the negative process. In order to create a chain scissioning reaction the backbone of this polymer would preferably include a free radicle of acylatate functionality in the chain, which is hydrolized by the acid. Thus, the regions which receive an exposure great enough to activate the second PAG would revert back to a soluble form.

Although specific embodiments of the present invention are herein described, they are not to be construed as limiting the scope of the invention. Many embodiments of the present invention will become apparent to those skilled in the art in light of methodology of the specification.

## Claims

1. A photoresist system for high resolution lithography comprising:
a first photoactive compound capable of being activated at a first value of a characteristic to create a first reaction;
a second photoactive compound capable of being activated at a second value of said characteristic which is different than said first value of said characteristic; and
wherein said activation of said second photoactive compound annuls said first reaction.

2. The photoresist system of Claim 1, wherein said first value of said characteristic is less than said second value of said characteristic.

3. The photoresist system of Claim 1, wherein said first value of said characteristic is greater than said second value of said characteristic.

4. The photoresist system of any preceding Claim, wherein said characteristic is an energy level.

5. The photoresist system of any of Claims 1 to 3, wherein said characteristic is frequency.

6. The photoresist system of any of Claim 1 to 3, wherein said characteristic is chemical makeup.

7. The photoresist system of Claim 2, wherein regions of said photoresist system that are exposed to energy at least as great as said first value but not as great as said second value becomes more soluble in a subsequent rinse step and regions of said photoresist system that are exposed to energy greater than said second value become less soluble in said subsequent rinse step.

8. The photoresist system of Claim 2, wherein regions of said photoresist system that are exposed to energy at least as great as said first value but not as great as said second value becomes less soluble in a subsequent rinse step and regions of said photoresist system that are exposed to energy greater than said second value become less soluble in said subsequent rinse step.

9. A method of fabricating semiconductor devices using high resolution lithography, said method comprising the steps of:
providing a semiconductor substrate;
forming a plurality of layers of material on said substrate;
patterning said plurality of layers by forming a photoresist layer on said layers, said photoresist layer comprising a first photoactive compound which is activated at a first energy level so as to create a first reaction and a second photoactive compound which is activated at a second energy level which is greater than said first energy level; and
wherein said activation of said second photoactive compound annuls said first reaction so as to provide said higher resolution lithography.

10. The method of Claim 9, further comprising exposing regions of said photoresist layer to energy at least as great as said first energy level but not as great as said second energy level such that said regions become more soluble in a subsequent rinse step and exposing regions of said photoresist layer to energy greater than said second energy level such that said regions become less soluble in said subsequent rinse step.

11. The method of Claim 9, further comprising exposing regions of said photoresist layer to energy at least as great as said first energy level but not as great as said second energy level such that said regions become less soluble in a subsequent rinse step and exposing regions of said photoresist layer to energy greater than said second energy level such that said regions become less soluble in said subsequent rinse step.

12. A method of patterning a resist layer comprising the steps of:
forming a resist layer on a substrate;
directing radiation with a first energy level toward a first portion of said resist layer, said radiation interacting with said resist so as to make said resist layer more soluble; and
directing radiation with a second energy level toward a second portion of said resist layer, said radiation interacting with said second portion of said resist layer so as to make said second portion of said resist layer less soluble.

13. The method of claim 12, wherein said step of directing radiation of said first energy level comprises directing radiation greater than said second energy level.

14. The method of Claim 12 or Claim 13, wherein said step of directing radiation of said second energy level comprises directing radiation greater than said first energy level.
